# EUROPEAN PATENT APPLICATION

(11) **EP 2 779 241 A1**
(43) Date of publication of application: **17.09.2014**
(21) Application number: 14000884.8
(22) Date of filing: 12.03.2014
(51) Int. Cl.: H01L 29/40, H01L 29/735

(54) **Bipolar transistor with lowered 1/F noise**

(30) Priority: 14.03.2013 US 201313829598
(71) Applicant: Linear Technology Corporation, Milpitas, CA 95035-7417 (US)
(72) Inventor: Botker, Thomas Lloyd, Andover, MA 01810 (US)
(74) Representative: Müller-Boré & Partner Patentanwälte PartG mbB

(57) **Abstract**

In a bipolar transistor, a thin gate oxide, preferably less than 600Å, is formed over the base surface region between the emitter and collector. A conductive gate, such as doped polysilicon, is then formed over the gate oxide and biased at the emitter voltage. In the example of a PNP transistor, when the emitter is forward biased with respect to the base to turn the transistor on, the gate is at a positive potential relative to the base. This causes the holes in the base conducting the emitter-collector current to be repelled away from the surface, and the electrons in the base to be attracted to the surface, so that more of the emitter-collector current flows deeper into the base. Thus, the effect of defects at the base surface is mitigated, and 1/f noise is reduced. The invention is equally applicable to PNP and NPN transistors. Other benefits result.

## Description

### FIELD OF THE INVENTION

This invention relates to bipolar transistors and, in particular, to a technique for reducing low frequency noise in such transistors.

### BACKGROUND

In a lateral bipolar transistor, the majority of the current flows near the surface of the silicon rather than vertically down into the silicon, in contrast to a vertical transistor.

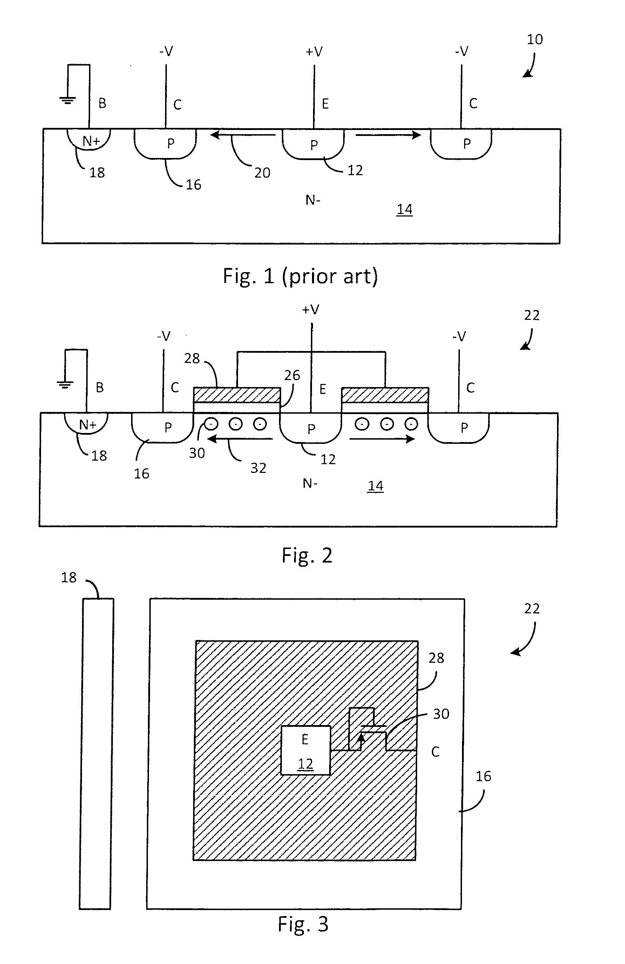

Fig. 1 is a simplified cross-sectional view of a typical lateral PNP bipolar transistor 10. A central P-type emitter 12 is formed in an N-type base 14 (an epitaxial tub), grown on a silicon substrate. Surrounding the emitter 12 is a P-type collector 16, formed as a ring, which may be generally rectangular or circular. A base contact region 18 makes electrical contact to the base 14. To turn the transistor 10 on, the emitter 12 is forward biased with respect to the base 14, and the collector 16 is reversed biased with respect to the base 14. Carriers from the emitter 12 (holes) entering the depletion region are swept into the collector 16 by the electric field, resulting in amplification (gain) of the base current. The transistor operates over a range of frequencies, and noise inherently occurs in the amplified signal due to the device physics. Generally, noise increases at very low frequencies.

The crystalline structure of the silicon enables such transistor operation. One contributor of low frequency noise, also known as 1/f noise, is due to surface defects as a result of the crystalline structure being discontinuous at the base's surface between the base-emitter interface and the base-collector interface. Such 1/f noise sets a limit on the minimum detectable signal at the low frequencies.

The surface defects increase the recombination of the carriers in the base near the surface, where the electronic band structure changes. This is believed due to charge traps caused by the defects in the crystalline structure near the surface.

In the example of Fig. 1, due to the surface defects, the percentage of holes from the emitter 12 entering the base 14 that recombine with electrons in the base 14 is increased near the surface of the base 14. In a lateral bipolar transistor, most of the emitter-collector current 20 flows near the surface since the emitter and collector doped regions are relatively shallow. Therefore, the effect of the surface defects is significant. The reason why the noise is 1/f related is extensively discussed in various published papers and is well known.

The surface defect problem also occurs to a much smaller extent in some vertical bipolar transistors, since a portion of the emitter-base interface is near the surface of the silicon. In such transistors, some current flows laterally in the base near the surface. Such lateral flow that takes place near the surface is affected by the surface defects, resulting in 1/f noise.

It is desirable for various applications, such as test equipment, data acquisition, and A/D converters, to lower the 1/f noise corner. The 1/f corner is where the 1/f noise drops down to meet the white noise level.

### SUMMARY

The invention repels the minority carriers in the base region (e.g., holes for an N-type base) near the base region surface to cause the lateral current flow to take place further below the surface between the emitter and collector regions to mitigate the effect of surface defects between the emitter and collector regions.

A thin gate oxide, such as less than 600 Angstroms (Å), is formed over the base surface region between the emitter and collector. The thin gate oxide should have minimal mobile charges and be of a very high quality, such as a thermally grown oxide. A conductive gate, such as doped polysilicon, is then formed over the gate oxide and biased at the emitter voltage (or other voltage more positive than the base for a PNP transistor).

In the example of a PNP transistor, when the emitter is forward biased with respect to the base to turn the transistor on, the gate is at a positive potential relative to the base. This causes the holes in the base near the surface, conducting the emitter-collector current, to be repelled away from the surface and causes electrons in the base to be attracted to the base surface, so that the conduction (hole current) is carried out further from the surface. Thus, there is less recombination at the surface due to the surface defects, and 1/f noise is reduced. Thus, the 1/f corner is lowered.

This technique is applicable to lateral NPN transistors as well. In either a PNP or NPN transistor, the gate's electric field repels the base's minority carriers near the base surface to cause more lateral current to flow deeper into the silicon to mitigate the effect of the surface defects.

By making a high quality gate oxide, there will be minimal mobile charges in the oxide that would affect the repulsion of the minority carriers in the base, and the gate oxide may be formed very thin to generate a high electric field, yet have a sufficiently high breakdown voltage. A plasma-grown gate oxide is generally not desirable since such an oxide typically includes mobile charges as a result of the plasma process.

There is no lower limit to the thinness of the gate oxide, except for its ability to withstand the voltage across the gate oxide without breaking down.

Other embodiments are described.

### BRIEF DESCRIPTION OF THE DRAWINGS

Fig. 1 is a cross-sectional view of a prior art lateral PNP bipolar transistor.
Fig. 2 is a cross-sectional view of a lateral PNP bipolar transistor in accordance with one embodiment of the invention.
Fig. 3 is a top down view of the transistor of Fig. 2.

Elements that are the same or equivalent are labeled with the same numeral.

### DETAILED DESCRIPTION

The invention reduces the surface effect contributing to 1/f noise in a lateral or vertical bipolar transistor. The invention is applicable to PNP and NPN transistors. A lateral PNP transistor is used in the example. The invention is applicable to a vertical bipolar transistor to the extent that the vertical transistor operation involves some lateral current flow near the base surface.

Historically, conventional vertical transistors typically have lower 1/f noise than conventional lateral transistors. In a test of a lateral transistor implementing the present invention, the resulting 1/f noise of the lateral transistor was lower than the 1/f noise of a high quality vertical transistor and lower than any bipolar transistor known to the inventor. Therefore, the 1/f corner was reduced.

Fig. 2 is a cross-sectional view of a lateral PNP bipolar transistor 22 in accordance with one embodiment of the invention. The emitter 12, base 14, collector 16, and base contact region 18 may be identical to the prior art Fig. 1 transistor. The base 14 is preferably epitaxially grown, rather than being implanted.

A high quality, thin gate oxide 26 is thermally grown, using conventional techniques, over the base 14 substantially between the emitter 12 and collector 16. The gate oxide 26 may have a thickness less than 1000Å, and preferably less than 600Å**.** In one embodiment, the gate oxide 26 is between 200-300Å. By thermally growing the gate oxide 26, rather than growing it using a plasma process, there are minimal mobile charges in the oxide 26. A high quality, thermally grown gate oxide 26 of a given thickness can also withstand a greater voltage than a plasma-grown oxide, enabling the gate oxide 26 to be made slightly thinner (e.g., less than 300Å) while not breaking down using standard operating voltages, such as 5 volts. A thinner oxide 26 enables the creation of a higher electrical field in the underlying silicon with a given voltage across the base/gate.

A conductive gate 28 is then formed over the gate oxide 26. The gate 28 may be a highly doped polysilicon or a metal. The gate 28 is electrically tied to the emitter 12, such as with a metal trace, so as to have a positive potential relative to the underlying base 14 when the emitter-base junction is forward biased to turn on the transistor 22. Tying the gate 28 to the emitter typically ensures that the parasitic PMOS device formed by the gate 28 stays off. Alternatively, the gate 28 may be coupled to any suitable voltage more positive than the base 14, for a PNP transistor. The gate voltage should be constant when the transistor is conducting to avoid any modulation.

When the transistor 22 is on, the positive potential on the gate 28 generates an electric field that repels the holes in the base (i.e., the minority current in the base) away from the surface and causes electrons 30 near the base 14 surface to accumulate at the surface. This forces the hole current 32 (between the emitter 12 and collector 16) to occur below the surface of the base 14 and away from the surface traps. Therefore, the 1/f noise is reduced and the 1/f corner occurs at a lower frequency.

Dielectric layers other than an oxide may be formed instead of the oxide 26.

In an actual embodiment, due to diffusion of dopants in the emitter and collector during processing of the silicon wafer, the gate 28 may ultimately extend over the base-emitter and base-collector interfaces somewhat, which is preferred.

This technique of reducing the effect of surface defects in a lateral bipolar transistor is equally applicable to a lateral NPN transistor, where all the polarities in the transistor 22 are reversed. The gate 28 is then negatively biased with respect to the P-type base when the transistor is on, causing holes in the P-type base to accumulate at the surface and electrons (i.e., the minority current in the base) to be repelled by the gate 28. This forces the electron current between the N-type emitter and N-type collector below the surface of the base and away from the surface traps. Therefore, the 1/f noise is reduced and the 1/f corner occurs at a lower frequency.

Fig. 3 is a top down view of the transistor 22 of Fig. 2. The regions are shown rectangular but would often have rounded corners or may be circular. The insulated gate 28 over the base 14 is shown to create a parasitic PMOS device 30 with a Vgs of 0 volts (if the gate 28 is tied to the emitter 12).

In one embodiment, a thick second oxide layer (e.g., about 0.6 micron or greater) is formed over the gate 28, where the second oxide layer has openings over the emitter 12 and the gate 28 conductor material. An emitter metal is then deposited over the second oxide layer to form the emitter conductor and short the gate 28 to the emitter 12. Other means may be used to short the gate 28 to the emitter 12.

Although the gate 28 is shown formed over substantially the entire base 14 between the emitter 12 and collector 16 to maximize the effectiveness of the invention, the gate 28 can be smaller to reduce the effect of the surface defects over a smaller portion of the base.

Instead of the base 14 being epitaxially grown over a silicon substrate, the base may be a doped region formed by masking and doping a region of a silicon surface. The emitter and collector are then formed in the doped base region or otherwise in contact with the doped base region.

The invention is particularly applicable to precision devices used for DC measurement as well as to circuits that up-convert 1/f noise, such as phase locked loop circuits. The invention has also been shown to cause reductions in offset shifts during burn in and to reduce long term drift (e.g., change in Vbe over time). These were unexpected and significant benefits. This allows amplifier and reference circuits incorporating the lateral bipolar transistors to be more stable over the lifetime of the product so as to be more valuable for precision DC measurements.

It is known to form a thick oxide (e.g., greater than I micron) over the entire surface of a lateral transistor, followed by forming a metal shield layer over the thick oxide in electrical contact with the emitter. Such thick oxide is usually plasma-grown (typically lower quality oxide) rather than thermally grown to quickly develop the required thickness. The thick oxide may also be used for planarization. The metal shield layer over the thick oxide has a blocking function by reducing the effects of fields generated above the transistor such as the fields created by overlying conductors or the field created by electrical charges within the plastic package. Such metal, even if biased with the emitter voltage, would only form a very weak coupling to the base due to the oxide thickness and would not have a significant effect on lowering the 1/f corner. In contrast to such prior art thick oxides and the "blocking" shields, the present invention controls the surface charges by coupling a relatively large electrical field to the base near the surface due to the thinness of the gate oxide.

If the prior art metal shield layer, separated from the transistor surface by a thick oxide (typically plasma-grown), was biased with a higher potential than the emitter potential (for a PNP transistor) in an attempt to mitigate the effect of surface defects, the required potential would be too high to be practical. Accordingly, there is no suggestion to use the prior art shield layer to reduce the effect of surface defects.

While particular embodiments of the present invention have been shown and described, it will be obvious to those skilled in the art that changes and modifications may be made without departing from this invention in its broader aspects. The appended claims are to encompass within their scope all such changes and modifications as fall within the true spirit and scope of this invention.

## Claims

1. A bipolar transistor comprising:
an emitter of a first conductivity type;
a collector of the first conductivity type;
a base of a second conductivity type between the emitter and the collector, the base having a surface portion, the emitter, base, and collector forming a bipolar transistor;
a gate dielectric formed over at least a portion of the surface portion of the base between the emitter and collector; and
a conductive gate formed over the gate dielectric, the gate being coupled to a voltage potential, the gate dielectric and voltage potential being such that, when the transistor is turned on by forward biasing the emitter relative to the base, a resulting electric field generated by the gate forces more minority current in the base to be conducted deeper beneath the surface portion of the base between the emitter and collector.

2. The transistor of Claim 1 wherein the transistor is a lateral transistor.

3. The transistor of Claims 1 or 2 wherein the gate dielectric is less than 1000 Angstroms thick; or
wherein the gate dielectric is less than 600 Angstroms thick; or
wherein the gate dielectric is less than 300 Angstroms thick.

4. The transistor of any of the preceding claims wherein the gate dielectric is thermally grown.

5. The transistor of any of the preceding claims wherein the gate is coupled to the emitter so as to have the same potential as the emitter.

6. The transistor of any of the preceding claims wherein the transistor is a PNP type, and the gate is connected to a voltage more positive than the base; or
wherein the transistor is an NPN type, and the gate is connected to a voltage more negative than the base.

7. The transistor of any of the preceding claims wherein the resulting electric field generated by the gate reduces 1/f noise in the transistor; and/or
wherein the resulting electric field generated by the gate lowers a 1/f noise corner of the transistor.

8. The transistor of any of the preceding claims wherein the base is epitaxially grown.

9. A method of operating a bipolar transistor, the transistor comprising an emitter of a first conductivity type, a collector of the first conductivity type, and a base of a second conductivity type between the emitter and the collector, the base having a surface portion between the emitter and the collector, the method comprising:
turning on the transistor by forward biasing the emitter relative to the base; and
applying a voltage to a conductive gate, insulated from the surface portion by a gate dielectric, such that minority carriers in the base are repelled from the surface portion by an electric field created between the base and the gate to force more minority current in the base to be conducted deeper beneath the surface portion of the base between the emitter and collector.

10. The method of Claim 9 wherein the gate dielectric does not extend completely over the emitter and collector.

11. The method of Claims 9 or 10 wherein the transistor is a lateral transistor; and/or
wherein the gate dielectric is less than 1000 Angstroms thick; and/or
wherein the gate dielectric is less than 600 Angstroms thick.

12. The method of any one of claims 9 to 11 further comprising thermally growing the gate dielectric.

13. The method of any one of claims 9 to 12 wherein the step of applying the voltage to the gate comprises coupling the gate to the emitter so as to have the same potential as the emitter.

14. The method of any one of claims 9 to 13 wherein the transistor is a PNP type, and the gate is connected to a voltage more positive than the base; or
wherein the transistor is an NPN type, and the gate is connected to a voltage more negative than the base.

15. The method of any one of claims 9 to 14 wherein the resulting electric field generated by the gate reduces 1/f noise in the transistor; and/or
wherein the resulting electric field generated by the gate lowers a 1/f noise corner of the transistor.
